# FASCICULE DE BREVET EUROPEEN

(11) **EP 4 199 025 B1**
(45) Date de publication et mention de la délivrance du brevet: **19.06.2024**
(21) Numéro de dépôt: 22213937.0
(22) Date de dépôt: 15.12.2022
(51) Int. Cl.: H01H 71/04, H01H 71/08, H01H 73/20, G01R 31/66, H01H 11/00, G01R 19/155, G01R 27/20

(54) **DISPOSITIF POUR MESURER UNE TEMPÉRATURE ET UNE TENSION ÉLECTRIQUE ENTRE DEUX BORNES DE RACCORDEMENT ÉLECTRIQUE D'UN APPAREIL DE PROTECTION ÉLECTRIQUE**
VORRICHTUNG ZUR MESSUNG DER TEMPERATUR UND DER ELEKTRISCHEN SPANNUNG ZWISCHEN ZWEI ANSCHLÜSSEN EINER ELEKTRISCHEN SCHUTZVORRICHTUNG
DEVICE FOR MEASURING A TEMPERATURE AND AN ELECTRICAL VOLTAGE BETWEEN TWO ELECTRICAL TERMINALS OF AN ELECTRICAL PROTECTION DEVICE

(30) Priorité: 16.12.2021 FR 2113663
(43) Date de publication de la demande: 21.06.2023
(73) Titulaire: SCHNEIDER ELECTRIC INDUSTRIES SAS, 92500 Rueil-Malmaison (FR)
(72) Inventeur: PUPIN, Thomas, 38100 GRENOBLE (FR); TIAN, Simon, 38330 SAINT-ISMIER (FR)
(74) Mandataire: Lavoix

(56) Documents cités:
- FR-A1- 3 019 302
- JP-A- H06 139 912
- KR-A- 20140 032 261
- US-B2- 10 818 459

## Description

### DOMAINE TECHNIQUE

La présente invention concerne un dispositif pour mesurer une température et une tension électrique entre deux bornes de raccordement électrique d'un appareil de protection électrique. L'invention concerne également un ensemble comportant un tel dispositif et un appareil de protection électrique.

### ARRIERE-PLAN TECHNOLOGIQUE

L'invention concerne la surveillance d'appareils de protection électrique, tels que des disjoncteurs, utilisés dans des installations de distribution d'électricité.

De façon connue, de tels appareils de protection électrique comportent des bornes de raccordement qui sont configurées pour accueillir chacune un conducteur électrique, tel qu'un câble, afin de connecter électriquement l'appareil de protection à d'autres appareils de l'installation. Par exemple, une vis de serrage permet d'assurer un contact mécanique avec ledit conducteur électrique.

Toutefois, au cours de la vie de l'appareil de protection, il est fréquent qu'un ou plusieurs de ces câbles se déconnecte au moins partiellement de la borne de fixation, par exemple parce que la vis de serrage se desserre.

Ce phénomène peut avoir de nombreuses causes.

Par exemple, les vis de serrage peuvent se desserrer à cause de vibrations mécaniques auxquelles est assujetti l'appareil de protection durant son fonctionnement. De plus, le passage intermittent du courant alternatif dans les conducteurs crée des cycles thermiques répétés qui amènent divers éléments métalliques à se dilater thermiquement puis à se contracter, de façon cyclique, ce qui dégrade leur tenue mécanique. Par ailleurs, dans le cas où les câbles sont des câbles tressés, il peut arriver que les brins les plus fins se tassent après serrage, aboutissant à une perte partielle de contact avec les bornes de raccordement. Enfin, les conducteurs sont fréquemment réalisés en cuivre, qui a la propriété d'être un matériau mou et faiblement élastique, et qui donc se déforme facilement même sous une pression mécanique modérée, aboutissant là encore à une perte de contact.

Lorsqu'une borne de raccordement se desserre et que le contact électrique entre la borne de raccordement et le conducteur n'est plus assuré, alors la résistance de contact augmente, ce qui accroît les pertes thermiques par effet Joule et conduit à une élévation importante et rapide de la température. Cet échauffement va ensuite, lorsqu'il devient trop important, faire fondre le matériau plastique formant le boîtier de l'appareil de protection. Comme le boîtier n'assure alors plus son rôle d'isolant, il peut apparaître des arcs électriques entre les bornes de l'appareil de protection, ces arcs étant favorisés par l'échauffement de la température et la fonte de certains éléments métalliques qui ionisent l'air et rendent l'air ambiant électriquement conducteur. Tout cela peut au final causer un départ d'incendie et conduire à la destruction de l'appareil de protection, voire même de l'installation toute entière.

Il est donc important de maintenir un bon contact électrique au niveau des bornes de raccordement.

Pour parer à ces problèmes, il est connu de mettre en place une maintenance préventive périodique, par exemple en inspectant régulièrement au cours du temps chacune des bornes de raccordement pour resserrer celles qui sont desserrées, ou en utilisant des moyens de détection thermiques, comme une caméra infrarouge, pour identifier des points chauds et corriger le problème avant que l'installation électrique ne soit endommagée.

Cela présente de nombreux inconvénients. Une telle maintenance préventive est particulièrement lourde et coûteuse à mettre en oeuvre, surtout dans les installations qui présente un nombre important d'appareils de protection. Il existe aussi un risque qu'un défaut apparaisse entre deux visites consécutives, et que ce défaut ne puisse pas être détecté ni corrigé à temps, d'autant plus que ces visites de maintenance sont généralement réalisées assez peu fréquemment, par exemple au mieux avec une périodicité de plusieurs mois, voire d'une année.

Des solutions à base de capteurs ne donnent généralement pas entière satisfaction, car ces capteurs sont généralement coûteux et complexes à intégrer dans un appareil de protection, surtout lorsqu'un grand nombre de tels capteurs doit être déployée dans une installation électrique comportant plusieurs appareils de protection devant être surveillés.

C'est à ces inconvénients qu'entend plus particulièrement remédier l'invention en proposant un dispositif de mesure pour mesurer une température et une tension électrique entre deux bornes de raccordement électrique d'un appareil de protection électrique, afin de détecter un défaut sur une borne de raccordement, le dispositif de mesure étant peu coûteux et simple à mettre en oeuvre, y compris sur des appareils de protection existants.

### RESUME DE L'INVENTION

A cet effet, un aspect de l'invention concerne un dispositif de mesure pour mesurer une température et une tension électrique entre deux bornes de raccordement électrique d'un appareil de protection électrique, le dispositif de mesure comportant :
- un boîtier comportant au moins deux plots de couplage faisant saillie par rapport à une face du boîtier, chacun des plots de couplage étant conformé pour coopérer avec une des bornes de raccordement électrique ;
- un module de mesure de tension électrique comportant au moins deux contacts électriques réalisés dans un matériau électriquement conducteur et thermiquement conducteur, chaque contact électrique étant au moins partiellement reçu dans un des plots de couplage et étant conformé pour entrer en contact direct avec une borne de raccordement électrique de l'appareil de protection électrique lorsque le dispositif de mesure est monté sur l'appareil de protection électrique ;
- un capteur de température couplé thermiquement avec les contacts électriques ;
- un processeur couplé au capteur de température et au module de mesure de tension électrique ;
dans lequel le processeur est configuré pour analyser les données de température et de tension électrique mesurées, respectivement, par le capteur de température et par le module de mesure de tension et pour générer des données représentatives de la température des bornes de raccordement électriques et de la tension électrique entre les bornes de raccordement électriques, et dans lequel le processeur est configuré pour envoyer, en utilisant une interface de communication du dispositif de mesure, un message comportant les données générées.

Selon des aspects avantageux mais non obligatoires, un tel dispositif de mesure peut incorporer une ou plusieurs des caractéristiques suivantes, prises isolément ou suivant toute combinaison techniquement admissible :
- les contacts électriques sont aimantés ;
- chaque borne de raccordement comporte une vis de serrage en un matériau électriquement conducteur, ladite vis de serrage étant logée dans une cavité correspondante formée dans le boîtier dudit appareil de protection électrique, les cavités débouchant sur une face du boîtier, dans lequel chaque plot de couplage présente une forme complémentaire à celle de ladite cavité, et dans lequel le contact électrique est conformé pour être en contact direct avec ladite vis de serrage lorsque le dispositif de mesure est monté sur ledit appareil de protection électrique ;
- le boîtier comporte une forme de plaque plane, les plots de couplage s'étendant perpendiculairement en saillie par rapport à une même face principale du boîtier ;
- le boîtier comporte une première partie et une deuxième partie chacune en forme de plaque plane, la première partie et la deuxième partie de boîtier étant disposées perpendiculairement l'une par rapport à l'autre, les plots de couplage s'étendant perpendiculairement en saillie par rapport à une même face principale de la première partie du boîtier en étant parallèles à une face principale de la deuxième partie de boîtier ;
- au moins une partie des composants électroniques du dispositif de mesure sont logés à l'intérieur de la deuxième partie de boîtier ;
- le processeur est configuré pour générer une alerte lorsque la température déterminée à partir des mesures réalisées par le capteur de température dépasse un seuil prédéfini ;
- le processeur est configuré pour générer une alerte lorsque les données de tension déterminées à partir des mesures réalisées par le module de mesure de tension sont représentatives d'une absence de tension électrique entre les bornes de raccordement de l'appareil de protection électrique ;
- l'interface de communication est une interface de communication radiofréquence et dans lequel le message est un message radio ;
- le dispositif de mesure comporte un dispositif de récupération d'énergie connecté aux contacts électriques et étant configuré pour générer une tension électrique d'alimentation servant à alimenter électriquement le dispositif de mesure à partir de la tension électrique présente entre les contacts électriques.

Selon un autre aspect, l'invention concerne un ensemble comportant un appareil de protection électrique et un dispositif de mesure selon l'une quelconque des revendications précédentes, dans lequel le dispositif de mesure est monté sur l'appareil de protection électrique et dans lequel les contacts électriques sont connectés électriquement et thermiquement aux bornes de raccordement électrique de l'appareil de protection électrique ;

Selon un autre aspect, le dispositif de mesure est associé aux bornes de raccordement aval de l'appareil de protection électrique.

### BREVE DESCRIPTION DES FIGURES

L'invention sera mieux comprise et d'autres avantages de celle-ci apparaîtront plus clairement à la lumière de la description donnée uniquement à titre d'exemple et faite en référence aux dessins annexés, dans lesquels :
[Fig 1] la figure 1 représente un dispositif de mesure pour mesurer une température et une tension électrique entre deux bornes de raccordement électrique d'un appareil de protection électrique selon un premier mode de réalisation de l'invention, le dispositif de mesure y étant illustré seul (insert A) ou monté sur un appareil de protection électrique (insert B) ;
[Fig 2] la figure 2 est une autre représentation schématique du dispositif de mesure de la figure 1 monté sur un appareil de protection électrique, le dispositif de mesure étant représenté selon une vue en coupe transversale dans le plan de coupe II-II illustré sur l'insert B) de la figure 1 ;
[Fig 3] la figure 3 est un diagramme fonctionnel d'un système électronique de traitement du dispositif de mesure de la figure 1 ;
[Fig 4] la figure 4 est une représentation schématique d'une partie du dispositif de mesure de la figure 1, illustrée selon une vue en coupe transversale dans le plan de coupe de la figure 2 ;
[Fig 5] la figure 5 représente un dispositif de mesure pour mesurer une température et une tension électrique entre deux bornes de raccordement électrique d'un appareil de protection électrique selon un deuxième mode de réalisation de l'invention, le dispositif de mesure y étant illustré seul (insert A) ou monté sur un appareil de protection électrique (insert B) ;
[Fig 6] la figure 6 est un schéma bloc représentant un exemple de mise en oeuvre d'un procédé de fonctionnement du dispositif de mesure de la figure 1 ou de la figure 5.

### DESCRIPTION DETAILLEE DE MODES DE REALISATION DE L'INVENTION

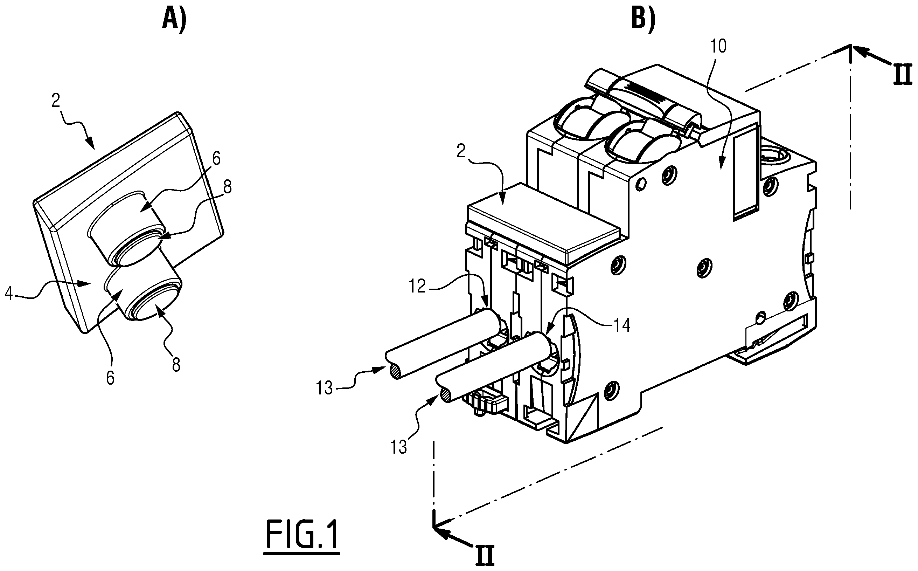

La figure 1 représente un premier mode de réalisation d'un dispositif de mesure 2 configuré pour mesurer une température et une tension électrique entre deux bornes de raccordement électrique d'un appareil de protection électrique 10.

Par exemple, l'appareil de protection 10 est un disjoncteur, tel qu'un disjoncteur miniature (MCB, pour « Miniature Circuit Breaker » en anglais), d'autres exemples étant toutefois possibles dans des modes de réalisation alternatifs. Par exemple, l'appareil de protection 10 pourrait être un interrupteur différentiel, ou un appareil de mesure.

L'appareil 10 est par exemple destiné à être monté sur un rail de fixation, généralement aux côtés d'autres appareils de protection. Par exemple, l'appareil de protection 10 est utilisé au sein d'une installation de distribution d'électricité. Plusieurs appareils de protection d'une même installation peuvent être équipés d'un dispositif de mesure 2.

L'appareil de protection 10 comporte des bornes de raccordement électrique 12, 14 qui permettent de raccorder l'appareil de protection 10 à une installation électrique. Ce raccordement est par exemple réalisé avec des conducteurs électriques 13, tels que des câbles. Chaque borne de raccordement 12, 14 peut être connectée électriquement à un conducteur électrique 13.

Le dispositif de mesure 2 est configuré pour être monté de façon stable et réversible sur l'appareil 10. En d'autres termes, le dispositif de mesure 2 est amovible. En variante, le dispositif de mesure 2 pourrait cependant être configuré pour être monté fixement et de façon irréversible sur l'appareil 10.

On définit une configuration de fonctionnement, dans laquelle le dispositif de mesure est couplé à, ou monté sur, l'appareil 10 pour mesurer une température et une tension électrique entre deux bornes de raccordement électrique de l'appareil de protection électrique 10.

Sur l'insert A de la figure 1, le dispositif de mesure 2 est illustré isolément, tandis que sur l'insert B de la figure 1, le dispositif de mesure 2 est illustré dans une configuration de fonctionnement, où le dispositif de mesure 2 est monté sur l'appareil de protection 10.

Le dispositif de mesure 2 comporte un boîtier 4 comportant au moins deux plots de couplage 6 faisant saillie par rapport à une face du boîtier. Les plots de couplage 6 ont par exemple une forme de tube creux, comme cela sera expliqué en détail dans ce qui suit. De préférence, les plots de couplage 6 du dispositif 2 ont une même forme, et sont par exemple identiques.

De préférence, le boîtier 4 est conformé de sorte à ne pas dépasser latéralement par rapport au boîtier de l'appareil 10 lorsque le dispositif 2 est en configuration assemblée, ceci afin d'éviter que le dispositif de mesure 2 n'empiète latéralement sur d'autres appareils de protection qui pourraient être placés à côté de l'appareil 10, comme c'est le cas lorsque plusieurs appareils de protection sont montés sur un même rail de fixation dans un tableau électrique. Par exemple, la largeur du boîtier 4 est inférieure ou égale à la largeur du boîtier de l'appareil de protection 10 (la largeur du boîtier 4 peut être mesurée lorsque le dispositif 2 est monté sur l'appareil 10). Ainsi, en pratique, le dispositif de mesure 2 peut être décliné en plusieurs versions de taille différente, en fonction des dimensions de l'appareil 10 avec lequel il est destiné à être associé, étant entendu que les dimensions des appareils de protection, tels que les disjoncteurs, sont généralement normalisées.

Chacun des plots de couplage 6 est conformé pour coopérer avec une des bornes de raccordement électrique de l'appareil de protection 10. En d'autres termes, chaque plot de couplage 6 est prévu pour être associé à une borne de raccordement de l'appareil 10.

De préférence, chaque plot de couplage 6 est prévu pour être associé à une borne de raccordement appartenant à une plage de raccordement aval de l'appareil 10. En variante, chaque plot de couplage 6 pourrait être associé à une borne de raccordement appartenant à une plage de raccordement amont de l'appareil 10. Dit autrement, dans la configuration de fonctionnement, le dispositif de mesure 2 est associé uniquement aux bornes de raccordement qui sont placées d'un seul côté (amont ou aval) de l'appareil.

Le nombre de plots de couplage 6 dans le dispositif 2 dépend du nombre de pôles de l'appareil de protection 10, et donc du nombre de bornes de raccordement de l'appareil de protection 10.

Dans l'exemple illustré, l'appareil de protection 10 est un appareil monophasé avec une ligne de neutre, et comporte donc deux pôles. Il y a ainsi deux pôles de chaque côté amont et aval de l'appareil de protection 10.

Dans des modes de réalisation alternatifs, qui ne sont pas illustrés mais auxquels la description est transposable, l'appareil de protection 10 pourrait être un appareil à trois pôles, ou un appareil quadripolaire, ou avec un nombre de pôles différent. C'est notamment le cas lorsque l'appareil 10 est utilisé dans une installation triphasée. Dans ces cas, le dispositif 2 peut comporter trois ou quatre plots de couplage 6, respectivement, d'autres variantes étant toutefois possibles. De préférence, lorsque le dispositif 2 comporte plus de deux plots 6 et qu'il est destiné à être couplé à plus de deux bornes de raccordement, alors le dispositif 2 est configuré pour mesurer la température de chacune de ces bornes de raccordement.

De préférence, le boitier 4 est réalisé en matériau électriquement isolant, par exemple en plastique. Les plots 6 font de préférence partie intégrante du boîtier 4, c'est-à-dire qu'ils sont formés d'un seul tenant avec le boîtier 4. Par exemple, le boîtier 4 est réalisé par un procédé de moulage.

Le dispositif de mesure 2 comporte un module de mesure de tension électrique comportant au moins deux contacts électriques 8 réalisés dans un matériau électriquement conducteur et thermiquement conducteur.

De préférence, les contacts électriques 8 sont réalisés en métal. Par exemple, chacun des contacts électriques 8 est une pièce métallique formée d'un seul tenant. Par exemple, les contacts électriques 8 du dispositif 2 ont une même forme, et par exemple sont identiques.

De façon particulièrement, avantageuse, les contacts électriques 8 sont aimantés, voire forment chacun un aimant permanent.

Cela permet aux contacts électriques 8 d'entrer en contact, de préférence en contact direct, avec les bornes de raccordement plus facilement et de rester en contact avec les bornes de raccordement même lorsque l'appareil 10 subit un léger déplacement ou des vibrations.

Par exemple, les contacts électriques 8 sont réalisés dans un matériau magnétique, de préférence un matériau ferromagnétique, tel que du fer, ou du cobalt, ou du nickel ou dans un alliage comportant un ou plusieurs de ces métaux. On peut également utiliser un alliage métallique à base de terres rares.

Par exemple, par « aimantés », on entend que chaque contact électrique 8 présente un moment magnétique supérieur permettant de résister à une force à l'arrachement égale à 5 newtons, ou plus, cet exemple n'étant pas limitatif.

Chaque contact électrique 8 est au moins partiellement reçu dans un des plots de couplage 6. Par exemple, chaque plot de couplage 6 délimite une enveloppe creuse à l'intérieur de laquelle un contact électrique 8 est placé.

Chaque contact électrique 8 est conformé pour entrer en contact direct avec une borne de raccordement électrique de l'appareil de protection électrique lorsque le dispositif de mesure est monté sur l'appareil de protection 10.

On comprend donc que chaque plot 6 présente une forme ouverte, de préférence à une de ses extrémités distales, pour permettre cette mise en contact.

Dans l'exemple illustré, les plots 6 ont chacun une forme de cylindre creux à base circulaire, dont l'extrémité distale est ouverte et débouche vers l'extérieur.

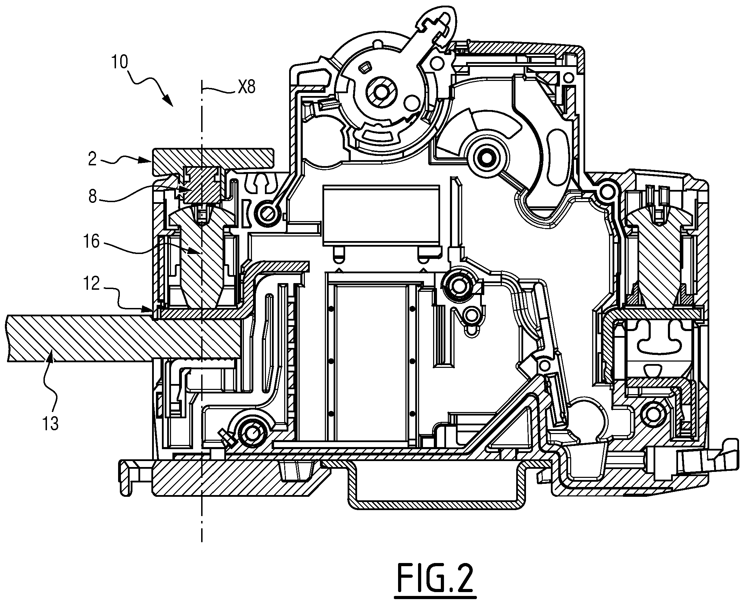

Comme illustré sur la figure 2, dans de nombreux modes de réalisation, chaque borne de raccordement 12, 14 de l'appareil 10 comporte une vis de serrage 16 réalisée en un matériau électriquement conducteur, tel que du métal.

Chaque vis de serrage 16 est logée dans une cavité (ou logement) correspondante formée dans le boîtier de l'appareil 10. Les cavités débouchant sur une face du boîtier, par exemple sur une face avant du boîtier comme dans l'exemple illustré sur les figures 1 et 2.

Avantageusement, chaque plot de couplage 6 présente une forme complémentaire à celle de ladite cavité, permettant au plot de couplage 6 d'être au moins partiellement inséré dans ladite cavité lorsque le dispositif de mesure 2 est monté sur l'appareil 10.

Le contact électrique 8 est conformé pour être en contact direct avec la vis de serrage 16 correspondante lorsque le dispositif de mesure 2 est monté sur l'appareil 10 dans la configuration de fonctionnement, comme visible sur la figure 2.

Par exemple, comme visible sur la figure 2 en référence à la borne de raccordement 12, chaque vis de serrage 16 est configurée pour permettre de maintenir en contact direct un conducteur électrique 13 tel qu'un câble de raccordement inséré dans la borne de raccordement 12 avec un terminal de raccordement installé fixement dans l'appareil 10.

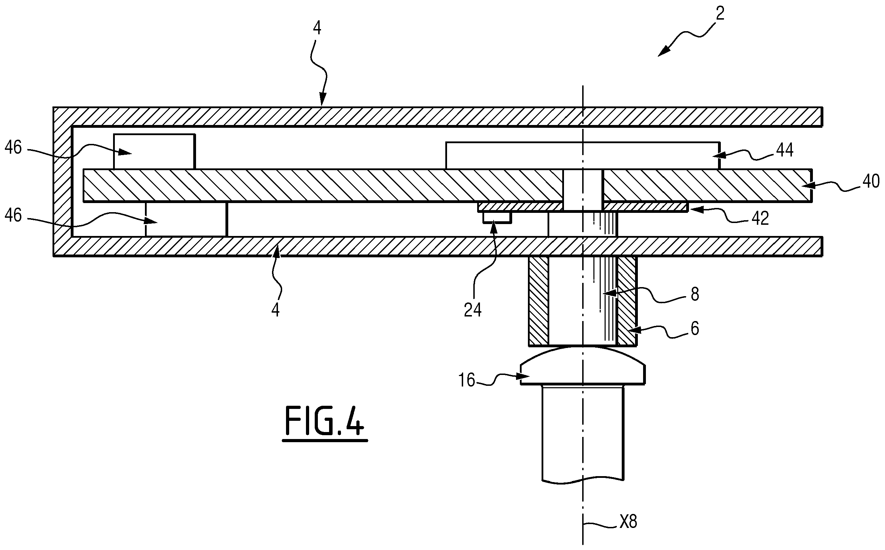

De préférence, dans la configuration assemblée, les contacts électriques 8 sont alignés ou essentiellement alignés avec les vis de serrage 16, par exemple en étant alignés ou essentiellement alignés le long d'un même axe (noté axe X8 sur la figure 2 et sur la figure 4).

Dans de nombreux modes de réalisation, les cavités ont une forme tubulaire ou cylindrique à base circulaire. Les plots 6 de forme cylindrique peuvent ainsi être insérés à l'intérieur des cavités, par exemple grâce à leur forme complémentaire et grâce à leurs dimensions, et notamment leur diamètre qui sont choisis en conséquence.

De préférence, le boîtier 4 est conformé pour présenter une forme au moins en partie complémentaire à la forme du boîtier de l'appareil 10, et de préférence avec la forme de la face avant du boîtier de l'appareil 10.

Par exemple, la fixation du boîtier 4 sur le boîtier de l'appareil 10 est assurée grâce aux contacts électriques 8 aimantés, qui permettent de maintenir le boîtier 4 plaqué contre la face correspondante du boîtier de l'appareil 10.

Dans d'autres modes de réalisation, le boîtier 4 pourrait comporter des éléments de retenue ou des éléments de fixation, tels que des crochets ou des éléments déformables d'encliquetage, permettant d'accrocher ou au moins retenir le boîtier 4 de façon stable et réversible au boîtier de l'appareil 10. Dans certains cas, les éléments de retenue peuvent retenir le boîtier 4 en exercent une force de frottement.

Dans un mode de réalisation préféré, tel qu'illustré sur les figures 1 et 2, le boîtier 4 a une forme de plaque plane ou essentiellement plane. Par exemple, au moins une des faces principales du boîtier 4 a une forme plane, de manière à pouvoir être plaquée en contact contre la face correspondante du boîtier de l'appareil 10 (notamment la face avant de l'appareil 10).

Les plots de couplage 6 sont quant à eux disposés de façon à s'étendre en saillie par rapport à une même face principale (ou paroi) du boîtier 4. Cette face est de préférence la face principale du boîtier 4 qui est tournée vers l'appareil 10 lorsque le dispositif 2 est dans la configuration de fonctionnement. De préférence, les plots de couplage 6 s'étendent perpendiculairement par rapport à ladite face du boîtier.

De préférence, l'épaisseur du boîtier 4, mesurée selon une direction perpendiculaire au plan d'une face principale du boîtier 4 est inférieure ou égale à 1 cm, et de préférence inférieure ou égale à 8mm, ou de préférence encore, inférieure ou égale à 4mm.

Cette forme simple et compacte permet de monter facilement le boîtier 4 (et donc le dispositif 2) sur l'appareil 10, par exemple sur une face avant de l'appareil 10, sans entraver le fonctionnement de l'appareil 10.

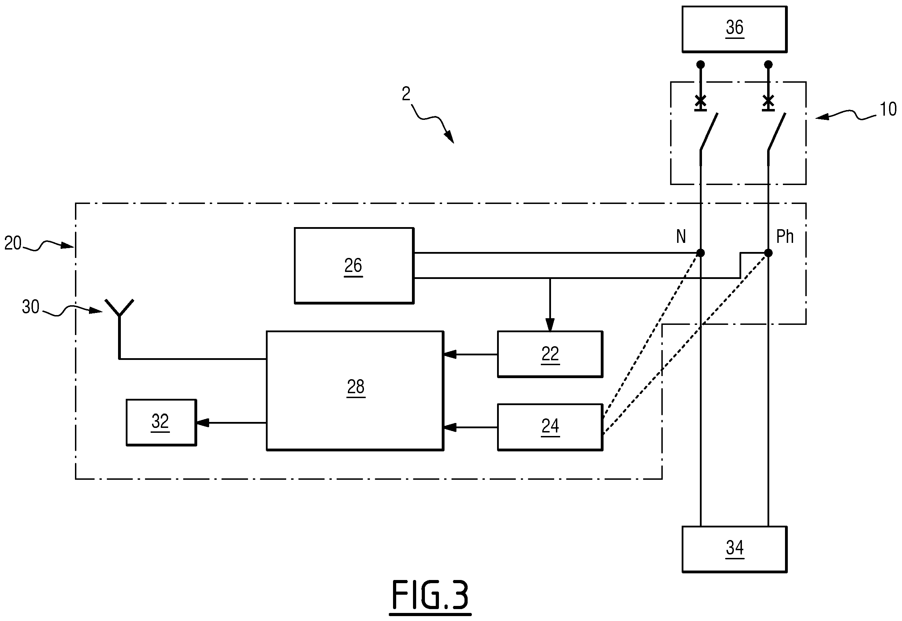

Comme illustré sur la figure 3, le dispositif de mesure 2 comporte aussi un système électronique de traitement 20 comprenant :
- un capteur de tension électrique 22,
- un capteur de température 24 couplé thermiquement avec les contacts électriques 8,
- un système d'alimentation électrique 26, et
- un processeur 28 couplé au capteur de température et au module de mesure de tension, le processeur 28 comportant une interface de communication 30 capable d'envoyer un message.

Optionnellement, le système électronique de traitement 20 peut aussi comporter un indicateur visuel 32, tel qu'un témoin lumineux, par exemple une diode électroluminescente (LED), cet indicateur 32 étant par exemple piloté par le processeur 28.

Dans l'exemple illustré, le dispositif 2 est associé à des bornes de raccordement aval de l'appareil 10. L'appareil 10 est ici connecté entre une charge électrique 34 et une source électrique 36 pour protéger la charge électrique 34. Le dispositif 2 est donc connecté en aval de l'appareil 10, en amont de la charge électrique 34.

Sur cette figure, la référence « Ph » indique le point de connexion entre un premier contact électrique 8 du dispositif de mesure 2 et une première borne de raccordement 12 de l'appareil 10, qui correspond ici à une phase électrique. La référence « N » indique le point de connexion entre un deuxième contact électrique 8 et une deuxième borne de raccordement 14 de l'appareil 10, qui correspond ici à la ligne de neutre.

Les traits pointillés entre les points de contact Ph, N et le capteur de température 24 représente un chemin de conduction thermique entre ces points de contact et le capteur de température 24.

Le capteur de tension 22 fait partie du module de mesure de tension électrique. Le capteur de tension 22 est configuré pour mesurer la tension électrique entre au moins deux des contacts électriques 8, par exemple en étant raccordé électriquement à au moins un des contacts électriques 8 (par exemple celui associé au point de connexion associé à la phase Ph), ou en étant raccordé électriquement aux deux contacts électriques 8.

Le capteur de tension 22 comporte par exemple un pont diviseur de tension, ou tout autre élément approprié ou équivalent.

Par exemple, le capteur de température 24 comporte une sonde de température au silicium, ou un thermocouple, ou une sonde de température à résistance (RTD), ou une sonde de température à infrarouge, ou une sonde de température à ondes acoustiques de surface (SAW), ou tout capteur de température approprié.

Dans de nombreux modes de réalisation, le dispositif d'alimentation électrique 26 est un dispositif de récupération d'énergie 26 connecté aux contacts électriques 8 et étant configuré pour générer une tension électrique d'alimentation à partir de la tension électrique présente entre les contacts électriques, la tension électrique d'alimentation étant utilisée pour alimenter électriquement le dispositif de mesure 2 et notamment le processeur 28.

De façon générale, le processeur 28 est configuré pour analyser les données de température et de tension électrique mesurées, respectivement, par le capteur de température 24 et par le module de mesure de tension 22 et pour générer des données représentatives de la température des bornes de raccordement électriques et de la tension électrique entre les bornes de raccordement électriques.

Par exemple, pour obtenir une information sur la température des bornes de raccordement (voire la température des vis de serrage 16 correspondantes) à partir de la température mesurée par le capteur 24, une correction peut être appliquée pour tenir compte de la nature des matériaux utilisés pour former le chemin de conduction thermique entre le capteur 24 et la vis de serrage 16, et éventuellement pour tenir compte des interfaces entre les différents éléments de ce chemin de conduction (par exemple, l'interface entre le contact électrique 8 et la tête de la vis de serrage 16). Cette correction peut, par exemple, être réalisée en corrigeant la température mesurée à l'aide d'un coefficient de correction ou d'une fonction de correction déterminée en fonction des caractéristiques de construction du dispositif 2 (tel que le dimensionnement ou la nature des matériaux utilisés dans le chemin de conduction, par exemple).

L'analyse des données peut également comporter le calcul de moyennes de la température et/ou de la tension à partir des données mesurées, par exemple pour éviter de déclencher inutilement une alarme en cas de fluctuation des valeurs mesurées dues à une anomalie ponctuelle de mesure, par exemple.

En pratique, le processeur 28 est couplé à une mémoire informatique, ou à tout support d'enregistrement de données lisible par ordinateur, qui comporte des instructions exécutables et/ou un code logiciel prévu pour mettre en oeuvre un tel procédé de fonctionnement lorsque les instructions et/ou le code sont exécutés par le processeur 28.

Le processeur 28 est, par exemple, un microcontrôleur ou un microprocesseur.

L'emploi du terme « processeur » ne fait pas obstacle à ce que, dans des modes de réalisation alternatifs, au moins une partie des fonctions du dispositif 2 soient réalisées par d'autres composants électroniques, tels qu'un processeur de traitement du signal (DSP), ou un composant logique reprogrammable (FPGA), ou un circuit intégré spécialisé (ASIC), ou tout élément équivalent, ou toute combinaison de ces éléments.

Avantageusement, le processeur 28 est configuré pour générer une alerte lorsque les données de tension déterminées à partir des mesures réalisées par le module de mesure de tension sont représentatives d'une absence de tension électrique entre les bornes de raccordement 12, 14 de l'appareil de protection électrique 10.

Cela permet de détecter une perte d'alimentation électrique susceptible de résulter d'une déconnexion d'une des bornes de raccordement.

De façon tout aussi avantageuse, le processeur 28 est configuré pour générer une alerte lorsque la température déterminée à partir des mesures réalisées par le capteur de température 24 dépasse un seuil prédéfini. Cela permet de détecter un échauffement anormal sur une des bornes de raccordement.

Le processeur 28 est aussi configuré pour envoyer, en utilisant l'interface de communication 30, un message comportant les données générées.

Dans de nombreux modes de réalisation, l'interface de communication 30 est une interface de communication radiofréquence permettant d'établir une communication sans fil, et comportant par exemple une antenne radio. Le message envoyé par le dispositif 2 est alors un message radio. Selon des exemples donnés à des fins d'illustration, l'interface de communication 30 est compatible avec le protocole de communication Zigbee (marque déposée), ou Bluetooth (marque déposée), ou avec tout protocole de communication sans fil analogue.

Dans d'autres modes de réalisation, l'interface de communication 30 peut être configurée pour établir une liaison câblée.

Dans tous les cas, le message envoyé par l'interface de communication 30 peut être un message d'alerte. Avantageusement, le processeur 28 peut être programmé pour que le message radio généré soit un message court, comportant par exemple une seule trame radio contenant une information représentative d'une alerte (comme un code d'erreur) ainsi qu'un identifiant propre au dispositif de mesure 2.

Dans de nombreux modes de réalisation, le processeur 28 peut être programmé pour envoyer des messages comportant les valeurs de tension et de température mesurées, voire éventuellement d'un indicateur sur le statut du dispositif 2 et/ou du statut de l'appareil 10, voire éventuellement une information relative à une alarme déclenchée à cause d'une perte de tension ou à cause d'une surchauffe. Ces messages sont de préférence envoyés périodiquement.

Les messages envoyés par le module 2 sont par exemple envoyés à un équipement informatique distant, par exemple par l'intermédiaire d'un concentrateur de données ou d'une passerelle installée localement.

La figure 4 illustre un exemple de construction du dispositif de mesure 2.

Dans de nombreux modes de réalisation, le dispositif de mesure 2 comporte un substrat 40, tel qu'un support de carte électronique 40, qui est logé à l'intérieur du boîtier 4 et qui est préférentiellement disposé parallèlement avec les parois principales du boîtier 4.

Le capteur de température 24 est monté sur le support, par exemple par soudage, et est raccordé aux contacts électriques 8 par l'intermédiaire de conducteurs électriques tels que des pistes métalliques 42 formées sur une face du support 40. Les pistes 42 assurent une conduction thermique entre le capteur de température 24 et les contacts électriques 8. Comme chacun des contacts électriques 8 est en contact direct avec une borne de raccordement, notamment avec une vis de serrage 16, cela permet au capteur de température de mesurer la température de la vis de serrage. Les pistes 42 sont de préférence formées sur la face du support 40 qui est tournée vers les plots 6.

Le dispositif de mesure 2 peut également comporter une plaque métallique 44 magnétique qui est disposée sur la face opposée du support 40 tout en étant en contact mécanique direct avec les contacts électriques 8, par exemple grâce à des orifices traversants ménagés dans le support 40 et qui permettent à une extrémité proximale des contacts électriques 8 d'être en contact avec la plaque 44. La « face opposée » du support 40 désigne la face principale du support 40 qui est opposée à la face tournée vers les plots 6.

La plaque métallique 44 sert à maintenir les contacts électriques 8 en position pendant des étapes de fabrication du boîtier 4, par exemple pendant des étapes d'un procédé de surmoulage.

La plaque métallique 44 peut néanmoins être omise dans d'autres modes de réalisation, par exemple lorsque le procédé de fabrication du boîtier 4 est différent.

Les blocs 46 illustrent de manière schématique l'emplacement pouvant être occupé par des composants du système électronique 20 à l'intérieur du boîtier 4. Ces composants peuvent, par exemple, correspondre au processeur 28, ou à des éléments du dispositif d'alimentation électrique 26. Ces composants peuvent par exemple être montés sur les deux faces du support 40, comme dans l'exemple illustré, ou sur seulement une des faces.

D'autres modes de réalisation sont néanmoins possibles.

Grâce à l'invention, le dispositif de mesure 2 permet d'identifier rapidement un défaut de connexion sur une borne de raccordement d'un appareil de protection électrique 10, en détectant une perte de tension électrique et/ou en détectant une température anormalement élevée sur une des bornes de raccordement.

Le dispositif 2 présente une forme compacte qui lui permet d'être facilement intégré à un appareil de protection existant 10. Le dispositif 2 peut être installé sur un appareil de protection 10 rapidement et facilement, par exemple par simple insertion des plots de raccordement 6 dans des cavités du boîtier de l'appareil 10.

En particulier, le dispositif 2 peut être installé sans avoir besoin de retirer les câbles de connexion 12 ou 14 de l'appareil 10 ni de démonter les bornes de raccordement. Au contraire, le dispositif 2 peut être simplement posé sur un appareil de protection 10 déjà en fonctionnement. Cela procure un gain de temps et une simplicité d'installation évidente.

Le dispositif 2 peut ainsi être facilement monté sur des appareils existants au sein d'une installation électrique existante et déjà en fonctionnement, ce qui est particulièrement avantageux pour réaliser des opérations de remise à niveau (« retrofitting » en anglais).

En outre, l'interface de communication radio 30 et le dispositif de récupération d'énergie 26 permettent au dispositif de mesure 2 de fonctionner de façon autonome et sans avoir besoin d'être connecté par des fils d'alimentation ou des fils de communication.

Enfin, le dispositif de mesure 2 est peu coûteux à produire, ce qui le rend facile à fabriquer et déployer à grande échelle.

Au final, on dispose ainsi d'un moyen sûr et fiable pour détecter un défaut sur une borne de raccordement d'un appareil de protection électrique, le dispositif de mesure étant peu coûteux et simple à mettre en oeuvre, y compris sur des appareils de protection existants.

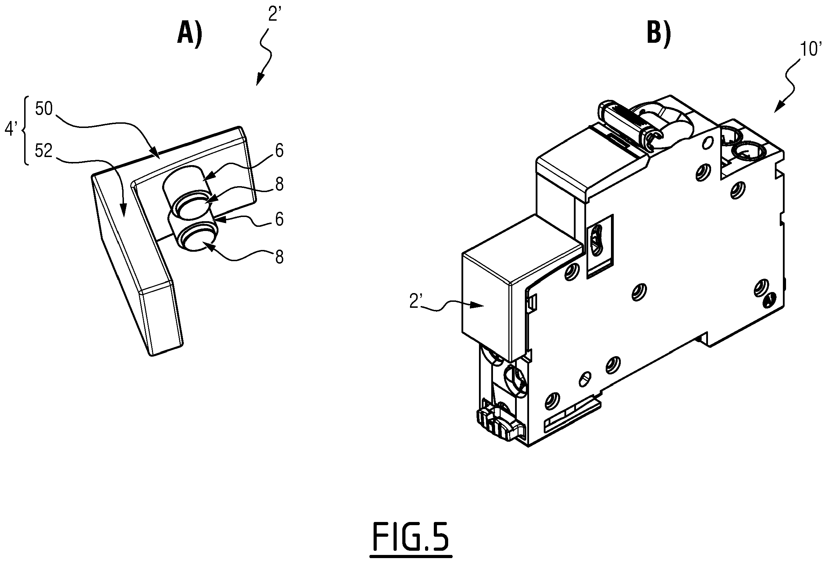

La figure 5 représente un deuxième mode de réalisation d'un dispositif de mesure 2' configuré pour mesurer une température et une tension électrique entre deux bornes de raccordement électrique d'un appareil de protection électrique.

Sur l'insert A de la figure 5, le dispositif de mesure 2' est illustré isolément, tandis que sur l'insert B de la figure 5, le dispositif de mesure 2' est illustré dans une configuration de fonctionnement, où le dispositif de mesure 2' est monté sur un appareil de protection 10' analogue à l'appareil de protection 10 précédemment décrit.

Dans ce dispositif de mesure 2', dont la fonction est similaire voire identique à celle du dispositif de mesure 2 précédemment décrit, la forme du boîtier 4' est modifiée de façon à présenter une forme en « L » au lieu de présenter une forme plane.

Notamment, le boîtier 4' comporte une première partie 50 et une deuxième partie 52 chacune en forme de plaque plane, la première partie et la deuxième partie de boîtier 50, 52 étant disposées perpendiculairement l'une par rapport à l'autre, de préférence au niveau d'un bord commun.

Les plots de couplage 6 du dispositif 2' s'étendent perpendiculairement en saillie par rapport à une même face principale de la première partie du boîtier 50 tout en s'étendant parallèlement à une face principale de la deuxième partie de boîtier 52.

Cette disposition permet d'augmenter le volume disponible à l'intérieur du boîtier 4' pour loger des composants du dispositif 2'.

Ce gain d'espace est particulièrement appréciable dans le cas où l'appareil de protection 10' présente un format réduit, notamment une largeur réduite, qui rendrait difficile voire impossible de stocker tous les composants dans un boîtier ayant une forme de plaque et étant placé en face avant de l'appareil. Dans l'exemple illustré, l'appareil de protection 10' a une épaisseur égale à 18mm. En variante, cette configuration de boîtier 4' en forme de L peut aussi être avantageusement utilisée avec des appareils plus larges, par exemple des appareils comportant trois ou quatre pôles, ou même avec l'appareil 10 précédemment décrit, dans le cas où il serait nécessaire de disposer d'un volume plus grand à l'intérieur du boîtier pour y stocker les composants du dispositif de mesure.

De préférence, au moins une partie des composants du dispositif de mesure 2', notamment les composants électroniques, sont logés à l'intérieur de la deuxième partie de boîtier 52.

Dans l'exemple illustré, lorsque le dispositif de mesure 2' est en configuration de fonctionnement monté sur l'appareil 10', alors la première partie de boîtier 50 est plaquée contre une partie de la face avant du boîtier de l'appareil 10' (puisque les ouvertures des cavités dans lesquelles sont logées les vis de serrage 16 débouchent sur la face avant), et la deuxième partie de boîtier 52 est plaquée contre une face inférieure ou supérieure du boîtier de l'appareil 10'. De préférence, l'épaisseur de chacune des parties de boîtier 50 et 52, mesurée selon une direction perpendiculaire au plan d'une face principale correspondante, est inférieure ou égale à 1 cm, et de préférence inférieure ou égale à 8mm, ou de préférence encore, inférieure ou égale à 6mm ou à 4mm.

Mis à part ces différences concernant la forme et l'agencement interne du dispositif de mesure, le fonctionnement et la composition du dispositif de mesure 2' selon le deuxième mode de réalisation sont semblables voire identiques à celles du dispositif de mesure 2 selon le premier mode de réalisation. Les éléments du dispositif de mesure 2' selon le deuxième mode de réalisation qui sont analogues au premier mode de réalisation portent les mêmes références et ne sont pas décrits en détail, dans la mesure où la description ci-dessus peut leur être transposée.

De nombreux autres modes de réalisation sont possibles.

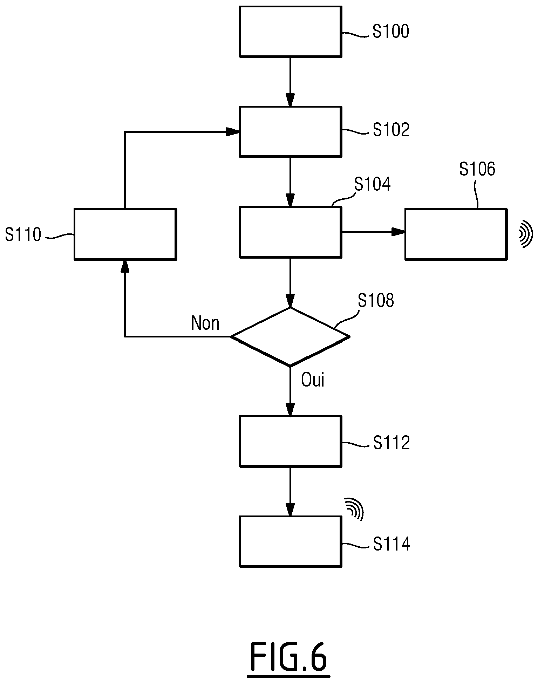

La figure 6 illustre un exemple de fonctionnement du dispositif de mesure 2 ou 2'.

Le procédé débute à l'étape S100 avec la mise sous tension du dispositif de mesure 2 et de l'appareil de protection 10 (qui peut être déjà en fonctionnement). Le dispositif 2 est dans la configuration de fonctionnement, monté sur l'appareil 10.

Lors d'une étape S102, le dispositif 2 mesure la température des bornes de raccordement et la tension électrique entre au moins deux bornes de raccordement, au moyen du capteur de température 24 et du capteur de tension 22, respectivement.

Lors d'une étape S104, le processeur 28 analyse automatiquement les données de température et de tension électrique mesurées, pour générer des données représentatives de la température des bornes de raccordement électriques et de la tension électrique entre les bornes de raccordement électriques.

De préférence, lors d'une étape S106, le dispositif 2 envoie automatiquement, grâce à l'interface de communication 30, un message comportant des informations telles que les valeurs de tension et de température mesurées, voire éventuellement d'un indicateur sur le statut du dispositif 2 et/ou du statut de l'appareil 10, voire éventuellement une information relative à une alarme déclenchée à cause d'une perte de tension et/ou à cause d'une surchauffe.

L'étape S106 peut être répétée périodiquement.

Lors d'une étape S108, le processeur 28 détermine automatiquement, à partir des informations relatives à la tension mesurée, si la tension électrique n'est pas présente entre les bornes de raccordement, ou si cette tension est inférieure à une valeur nominale. Par exemple, on vérifie automatiquement si la tension est comprise dans un intervalle prédéfini, ou si elle est inférieure ou égale à une valeur de seuil.

Dans le cas où la tension est toujours présente entre les bornes de raccordement, alors dans une étape S110, le processeur 28 détermine que le dispositif 2 est normalement alimenté électriquement et exécute à nouveau l'étape S102.

De préférence, les étapes S102 et S104 sont répétées périodiquement, en continu tout au long du fonctionnement du procédé, par exemple tant que le dispositif 2 est dans la configuration de fonctionnement en étant monté sur un appareil 10.

Dans le cas où, à l'issue de l'étape S108, la tension est identifiée comme n'étant plus présente entre les bornes de raccordement, alors dans une étape S112, le processeur 28 détermine que l'alimentation électrique du dispositif 2 perdue. En effet, en l'absence de tension électrique entre les bornes de raccordement, le dispositif de récupération d'énergie 26 ne peut plus alimenter le dispositif 2.

Dans ce cas, lors de l'étape S112, le processeur 28 ordonne l'enregistrement en mémoire des dernières valeurs de tension et de température, et éventuellement peut changer une variable d'état indiquant un état du dispositif 2.

Lors d'une étape S114, le processeur 28 commande l'envoi d'un message d'alerte par l'interface de communication 30. De préférence, ce message comporte une seule trame, contenant une information représentative d'une condition d'alerte (telle qu'un code d'erreur pouvant être associé à un identifiant du dispositif 2). Cela permet au message d'alerte d'être expédié au plus vite, en consommant le moins d'énergie possible, avant que le dispositif 2 ne soit arrêté. Ensuite, le processeur peut commander l'arrêt du dispositif 2.

Dans des modes de réalisation alternatifs, les étapes pourraient être exécutées dans un ordre différent. Certaines étapes pourraient être omises. L'exemple décrit ne fait pas obstacle à ce que, dans d'autres modes de réalisation, d'autres étapes soient mises en oeuvre conjointement et/ou séquentiellement avec les étapes décrites.

Notamment, les étapes S108 à S114 pourraient être omise dans le cas où le dispositif 2 comporte une source d'alimentation autonome, telle qu'une batterie, qui peut fournir au moins temporairement une alimentation électrique au dispositif d'alimentation 26.

Toute caractéristique de l'un des modes de réalisation ou variante décrite ci-dessus, peut être mise en oeuvre dans les autres modes de réalisation et variantes décrits.

## Revendications

1. Dispositif de mesure (2 ; 2') pour mesurer une température et une tension électrique entre deux bornes de raccordement électrique d'un appareil de protection électrique (10 ; 10'), le dispositif de mesure comportant :
• un boîtier (4 ; 4') comportant au moins deux plots de couplage (6) faisant saillie par rapport à une face du boîtier, chacun des plots de couplage étant conformé pour coopérer avec une des bornes de raccordement électrique ;
• un module de mesure de tension électrique comportant au moins deux contacts électriques (8) réalisés dans un matériau électriquement conducteur et thermiquement conducteur, chaque contact électrique étant au moins partiellement reçu dans un des plots de couplage (6) et étant conformé pour entrer en contact direct avec une borne de raccordement électrique de l'appareil de protection électrique lorsque le dispositif de mesure est monté sur l'appareil de protection électrique ;
• un capteur de température (24) couplé thermiquement avec les contacts électriques (8) ;
• un processeur (28) couplé au capteur de température et au module de mesure de tension électrique ;
dans lequel le processeur (28) est configuré pour analyser les données de température et de tension électrique mesurées, respectivement, par le capteur de température (24) et par le module de mesure de tension (22) et pour générer des données représentatives de la température des bornes de raccordement électriques et de la tension électrique entre les bornes de raccordement électriques, et dans lequel le processeur (28) est configuré pour envoyer, en utilisant une interface de communication (30) du dispositif de mesure, un message comportant les données générées.

2. Dispositif de mesure (2 ; 2') selon la revendication 1, dans lequel les contacts électriques (8) sont aimantés.

3. Dispositif de mesure (2 ; 2') selon l'une quelconque des revendications précédentes, dans lequel chaque borne de raccordement (12, 14) comporte une vis de serrage (16) en un matériau électriquement conducteur, ladite vis de serrage (16) étant logée dans une cavité correspondante formée dans le boîtier dudit appareil de protection électrique (10 ; 10'), les cavités débouchant sur une face du boîtier, dans lequel chaque plot de couplage (6) présente une forme complémentaire à celle de ladite cavité, et dans lequel le contact électrique (8) est conformé pour être en contact direct avec ladite vis de serrage (16) lorsque le dispositif de mesure est monté sur ledit appareil de protection électrique.

4. Dispositif de mesure (2) selon l'une quelconque des revendications précédentes, dans lequel le boîtier (4) comporte une forme de plaque plane, les plots de couplage (6) s'étendant perpendiculairement en saillie par rapport à une même face principale du boîtier.

5. Dispositif de mesure selon l'une quelconque des revendications précédentes, dans lequel le boîtier (4') comporte une première partie (50) et une deuxième partie (52) chacune en forme de plaque plane, la première partie et la deuxième partie de boîtier (50, 52) étant disposées perpendiculairement l'une par rapport à l'autre, les plots de couplage (6) s'étendant perpendiculairement en saillie par rapport à une même face principale de la première partie du boîtier (50) en étant parallèles à une face principale de la deuxième partie de boîtier (52).

6. Dispositif de mesure (2') selon la revendication 5, dans lequel au moins une partie des composants électroniques du dispositif de mesure (2') sont logés à l'intérieur de la deuxième partie de boîtier (52).

7. Dispositif de mesure (2 ; 2') selon l'une quelconque des revendications précédentes, dans lequel le processeur (28) est configuré pour générer une alerte lorsque la température déterminée à partir des mesures réalisées par le capteur de température (24) dépasse un seuil prédéfini.

8. Dispositif de mesure (2 ; 2') selon l'une quelconque des revendications précédentes, dans lequel le processeur (28) est configuré pour générer une alerte lorsque les données de tension déterminées à partir des mesures réalisées par le module de mesure de tension (22) sont représentatives d'une absence de tension électrique entre les bornes de raccordement (12, 14) de l'appareil de protection électrique (10 ; 10').

9. Dispositif de mesure (2 ; 2') selon l'une quelconque des revendications précédentes, dans lequel l'interface de communication (30) est une interface de communication radiofréquence et dans lequel le message est un message radio.

10. Dispositif de mesure (2 ; 2') selon l'une quelconque des revendications précédentes, dans lequel le dispositif de mesure comporte un dispositif de récupération d'énergie (26) connecté aux contacts électriques (8) et étant configuré pour générer une tension électrique d'alimentation servant à alimenter électriquement le dispositif de mesure à partir de la tension électrique présente entre les contacts électriques.

11. Ensemble comportant un appareil de protection électrique (10 ; 10') et un dispositif de mesure (2 ; 2') selon l'une quelconque des revendications précédentes, dans lequel le dispositif de mesure est monté sur l'appareil de protection électrique et dans lequel les contacts électriques (8) sont connectés électriquement et thermiquement aux bornes de raccordement électrique (12, 14) de l'appareil de protection électrique.

12. Ensemble selon la revendication 11, dans lequel le dispositif de mesure (2 ; 2') est associé aux bornes de raccordement aval de l'appareil de protection électrique.

## Patentansprüche

1. Messvorrichtung (2; 2') zum Messen einer Temperatur und einer elektrischen Spannung zwischen zwei elektrischen Anschlussklemmen eines elektrischen Schutzgeräts (10; 10'), wobei die Messvorrichtung umfasst:
• ein Gehäuse (4; 4') mit mindestens zwei Kopplungskontakten (6), die von einer Seite des Gehäuses vorstehen, wobei jeder der Kopplungskontakte so geformt ist, dass er mit einer der elektrischen Anschlussklemmen zusammenwirkt;
• ein Modul zur Messung der elektrischen Spannung mit mindestens zwei elektrischen Kontakten (8) aus einem elektrisch leitenden und wärmeleitenden Material, wobei jeder elektrische Kontakt zumindest teilweise von einem der Kopplungskontakte (6) aufgenommen wird und so geformt ist, dass er in direkten Kontakt mit einer elektrischen Anschlussklemme des elektrischen Schutzgeräts kommt, wenn die Messvorrichtung an dem elektrischen Schutzgerät angebracht ist;
• einen Temperatursensor (24), der thermisch mit den elektrischen Kontakten (8) gekoppelt ist;
• einen Prozessor (28), der mit dem Temperatursensor und dem Modul zur Messung der elektrischen Spannung gekoppelt ist;
wobei der Prozessor (28) konfiguriert ist, um die von dem Temperatursensor (24) bzw. dem Spannungsmessmodul (22) gemessenen Temperatur- und elektrischen Spannungsdaten zu analysieren und Daten zu erzeugen, die für die Temperatur und die elektrische Spannung der elektrischen Anschlussklemmen und der elektrischen Spannung zwischen den elektrischen Verbindungsanschlüssen repräsentativ sind, und wobei der Prozessor (28) so konfiguriert ist, dass er unter Verwendung einer Kommunikationsschnittstelle (30) der Messvorrichtung eine Nachricht sendet, die die erzeugten Daten enthält.

2. Messvorrichtung (2 ; 2') nach Anspruch 1, bei der die elektrischen Kontakte (8) magnetisch sind.

3. Messvorrichtung (2; 2') nach einem der vorhergehenden Ansprüche, wobei jede Anschlussklemme (12, 14) eine Klemmschraube (16) aus einem elektrisch leitenden Material aufweist, wobei die Klemmschraube (16) in einem entsprechenden Hohlraum aufgenommen ist, der sich in dem Gehäuse des elektrischen Schutzgeräts (10 ; 10') befindet, wobei die Hohlräume auf einer Seite des Gehäuses münden, wobei jeder Kopplungskontakt (6) eine Form aufweist, die komplementär zu der des Hohlraums ist, und wobei der elektrische Kontakt (8) so geformt ist, dass er sich in direktem Kontakt mit der Klemmschraube (16) befindet, wenn die Messvorrichtung an dem elektrischen Schutzgerät angebracht ist.

4. Messvorrichtung (2) nach einem der vorhergehenden Ansprüche, wobei das Gehäuse (4) eine flache Plattenform aufweist, wobei die Kopplungskontakte (6) sich senkrecht vorstehend von derselben Hauptfläche des Gehäuses erstrecken.

5. Messvorrichtung nach einem der vorhergehenden Ansprüche, wobei das Gehäuse (4') einen ersten Teil (50) und einen zweiten Teil (52) jeweils in flacher Plattenform aufweist, wobei der erste und der zweite Gehäuseteil (50, 52) senkrecht zueinander angeordnet sind, wobei die Kopplungskontakte (6) senkrecht von einer gleichen Hauptfläche des ersten Gehäuseteils (50) vorspringen und parallel zu einer Hauptfläche des zweiten Gehäuseteils (52) verlaufen.

6. Messvorrichtung (2') nach Anspruch 5, wobei zumindest ein Teil der elektronischen Komponenten der Messvorrichtung (2') innerhalb des zweiten Gehäuseteils (52) untergebracht sind.

7. Messvorrichtung (2; 2') nach einem der vorhergehenden Ansprüche, wobei der Prozessor (28) so konfiguriert ist, dass er eine Warnmeldung erzeugt, wenn die aus den Messungen des Temperatursensors (24) ermittelte Temperatur einen vordefinierten Schwellenwert überschreitet.

8. Messvorrichtung (2; 2') nach einem der vorhergehenden Ansprüche, wobei der Prozessor (28) so konfiguriert ist, dass er eine Warnung erzeugt, wenn die Spannungsdaten, die anhand der folgenden Daten bestimmt werden aus den von dem Spannungsmessmodul (22) durchgeführten Messungen repräsentativ für eine fehlende elektrische Spannung zwischen den Anschlussklemmen (12, 14) des elektrischen Schutzgeräts (10; 10') sind.

9. Messvorrichtung (2; 2') nach einem der vorhergehenden Ansprüche, wobei die Kommunikationsschnittstelle (30) eine Hochfrequenz-Kommunikationsschnittstelle ist, und wobei die Nachricht eine Funknachricht ist.

10. Messvorrichtung (2; 2') nach einem der vorhergehenden Ansprüche, wobei die Messvorrichtung eine Energierückgewinnungsvorrichtung (26) umfasst, die mit den elektrischen Kontakten (8) verbunden ist und die so beschaffen ist, dass sie aus der zwischen den elektrischen Kontakten vorhandenen elektrischen Spannung eine elektrische Versorgungsspannung erzeugt, die dazu dient, die Messvorrichtung elektrisch zu versorgen.

11. Anordnung mit einem elektrischen Schutzgerät (10; 10') und einer Messvorrichtung (2; 2') nach einem der vorhergehenden Ansprüche, wobei die Messvorrichtung an dem elektrischen Schutzgerät angebracht ist, und wobei die elektrischen Kontakte (8) elektrisch und thermisch mit den elektrischen Anschlussklemmen (12, 14) des elektrischen Schutzgeräts verbunden sind.

12. Anordnung nach Anspruch 11, bei der die Messvorrichtung (2; 2') den nachgeschalteten Anschlussklemmen des elektrischen Schutzgeräts zugeordnet ist.

## Claims

1. A measuring device (2; 2') for measuring a temperature and an electrical voltage between two electrical connection terminals of an electrical protection device (10; 10'), the measuring device comprising:
• a housing (4; 4') comprising at least two coupling studs (6) projecting from one face of the housing, each of the coupling studs being shaped to cooperate with one of the electrical connection terminals;
• an electrical voltage measuring module comprising at least two electrical contacts (8) made of an electrically conductive and thermally conductive material, each electrical contact being at least partially received in one of the coupling studs (6) and being shaped to come into direct contact with an electrical connection terminal of the electrical protection device when the measuring device is mounted on the electrical protection device;
• a temperature sensor (24) thermally coupled to the electrical contacts (8);
• a processor (28) coupled to the temperature sensor and the electrical voltage measurement module;
wherein the processor (28) is configured to analyse the temperature and electrical voltage data measured, respectively, by the temperature sensor (24) and the voltage measurement module (22) and to generate data representative of the temperature of the electrical connection terminals and the electrical voltage between the electrical connection terminals, and wherein the processor (28) is configured to send, using a communication interface (30) of the measuring device, a message comprising the generated data.

2. A measuring device (2; 2') according to claim 1, in which the electrical contacts (8) are magnetised.

3. A measuring device (2; 2') according to any of the preceding claims, wherein each connection terminal (12, 14) comprises a clamping screw (16) made of an electrically conductive material, said clamping screw (16) being housed in a corresponding cavity formed in the housing of said electrical protection device (10 ; 10'), the cavities opening onto one face of the housing, wherein each coupling stud (6) has a shape complementary to that of said cavity, and wherein the electrical contact (8) is shaped to be in direct contact with said clamping screw (16) when the measuring device is mounted on said electrical protection device.

4. A measuring device (2) according to any one of the preceding claims, in which the housing (4) has the shape of a flat plate, the coupling studs (6) extending perpendicularly and projecting with respect to the same main face of the housing.

5. A measuring device according to any one of the preceding claims, wherein the housing (4') comprises a first part (50) and a second part (52) each in the form of a flat plate, the first and second housing parts (50, 52) being arranged perpendicularly with respect to each other, the coupling studs (6) projecting perpendicularly with respect to the same main face of the first housing part (50) and being parallel to a main face of the second housing part (52).

6. A measuring device (2') according to claim 5, in which at least some of the electronic components of the measuring device (2') are housed inside the second housing part (52).

7. A measuring device (2; 2') according to any one of the preceding claims, in which the processor (28) is configured to generate an alert when the temperature determined from the measurements made by the temperature sensor (24) exceeds a predefined threshold.

8. A measuring device (2; 2') according to any one of the preceding claims, in which the processor (28) is configured to generate an alert when the voltage data determined from the measurements made by the voltage measuring module (22) are representative of an absence of electrical voltage between the connection terminals (12, 14) of the electrical protection device (10; 10').

9. A measuring device (2; 2') according to any one of the preceding claims, wherein the communication interface (30) is a radio frequency communication interface and wherein the message is a radio message.

10. A measuring device (2; 2') according to any one of the preceding claims, wherein the measuring device comprises an energy recovery device (26) connected to the electrical contacts (8) and configured to generate a supply electrical voltage for electrically powering the measuring device from the electrical voltage present between the electrical contacts.

11. An assembly comprising an electrical protection device (10; 10') and a measuring device (2; 2') according to any one of the preceding claims, in which the measuring device is mounted on the electrical protection device and in which the electrical contacts (8) are electrically and thermally connected to the electrical connection terminals (12, 14) of the electrical protection device.

12. An assembly according to claim 11, in which the measuring device (2; 2') is associated with the downstream connection terminals of the electrical protection device.
